(19) **Europäisches Patentamt**
**European Patent Office**
**Office européen des brevets**

(11) **EP 4 293 904 B1**

(12) **EUROPEAN PATENT SPECIFICATION**

(45) Date of publication and mention
of the grant of the patent:
**29.04.2026 Bulletin 2026/18**

(21) Application number: **22305859.5**

(22) Date of filing: **13.06.2022**

(51) International Patent Classification (IPC):
*H03G 3/30* (2006.01)  *H03G 7/00* (2006.01)
*H03G 11/00* (2006.01)

(52) Cooperative Patent Classification (CPC):
**H03G 3/3089; H03G 7/007; H03G 11/008;**
H03G 2201/106

(54) **AMPLITUDE LIMITING DEVICE AND METHOD FOR SIGNAL PROCESSING CHAIN**

VORRICHTUNG UND VERFAHREN ZUR AMPLITUDENBEGRENZUNG FÜR SIGNALVERARBEITUNGSKETTEN

DISPOSITIF DE LIMITATION D'AMPLITUDE ET PROCÉDÉ DE CHAÎNE DE TRAITEMENT DE SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.12.2023 Bulletin 2023/51**

(73) Proprietor: **L-Acoustics**
**91462 Marcoussis Cedex (FR)**

(72) Inventor: **SCHWANN, Robert**
**58511 Luedenscheid (DE)**

(74) Representative: **Novagraaf Technologies**
**2 rue Sarah Bernhardt**
**CS90017**
**92665 Asnières-sur-Seine Cedex (FR)**

(56) References cited:
**EP-A1- 2 369 852**  **US-A1- 2015 086 025**
**US-A1- 2015 207 471**  **US-A1- 2015 372 650**
**US-A1- 2018 103 313**

**Description**

<u>TECHNICAL FIELD</u>

Various example embodiments relate generally to an amplitude limiting device and a corresponding method for a signal processing chain.

<u>BACKGROUND</u>

In a system e.g., for FM (Frequency Modulation) broadcasting, where a discrete-time signal needs to be band limited before it is used to modulate a second signal (e.g., a subcarrier), amplitude overshoot may occur from band limiting and / or interpolation, which should be avoided or corrected before modulation.

In another system, where input samples representing a band-limited discrete-time signal are converted to a continuous-time signal, amplitude overshoot may occur during conversion, for example when the discrete-time signal contains out-of-band frequencies from clipping; or when a lowpass filter, a bandpass filter, or an interpolation filter is applied during conversion. One solution could be to apply an attenuation gain and / or a low-threshold clipping to all input samples to keep the magnitude of the continuous-time output always below a maximum level. But this would represent a too severe reduction of usable output amplitude range.

In addition, where the continuous-time analog signal from a DAC (Digital to Analog Converter) is amplified by an audio amplifier (e.g., a Pulse Width Modulation, PWM, amplifier) before the output amplified signal is fed to a loudspeaker, several artifacts may occur. Especially, the PWM power amplifier is sensitive to excessively high output voltages causing overmodulation of the PWM modulator, and if a too high magnitude of the input voltage amplified by this amplifier will cause an output voltage that is too close to the rail voltage, the amplifier may produce audible subharmonics.

There appears a need for an improved solution for avoiding amplitude overshoot produced by a subsequent device (e.g., performing at least one of band limiting, interpolating, up-sampling and in some case DAC conversion on a signal). Such a signal may be any signal, for example an audio signal, a broadcast signal, or a signal representing variations (e.g., over time) of a physical parameter (e.g., a voltage, or a mechanical position, etc.).

A typical use case or application is given when the subsequent device may produce "ringing" (as a consequence of the Gibbs phenomenon) at the output signal in response to a clipped input signal, or in response to an input signal containing peaks or steps.

US 2018/103313 A1, EP 2 369 852 A1, US 2015/372650 A1, US 2015/086025 A1, US 2015/207471 A1 disclose various devices for performing limitation on audio samples.

<u>SUMMARY</u>

The scope of protection is set out by the independent claims. The embodiments, examples, and features, if any, described in this specification that do not fall under the scope of the protection are to be interpreted as examples useful for understanding the various embodiments or examples that fall under the scope of protection.

The invention is defined by the appended claims.

<u>BRIEF DESCRIPTION OF THE DRAWINGS</u>

Example embodiments will become more fully understood from the detailed description given herein below and the accompanying drawings, which are given by way of illustration only and thus are not limiting of this disclosure.

In the following, a digital signal denotes a discrete-time signal with quantized amplitudes that is suitable for digital signal processing (DSP). Clipped samples denote samples from an input signal that have been modified by a clipping method. Reduced samples denote samples from a signal that have been modified by the herein described amplitude limiting method. A reduced sample has the same sign (positive or negative), but a lower magnitude than the original input sample.

FIG. 1A shows a section of a frequency sweep digital input signal (with a peak amplitude of $\pm\sqrt{2}$) and corresponding 4-fold interpolated signal values, generated by a subsequent device, or measured at the output of the subsequent device according to an example.

FIG. 1B shows a section of this digital input signal, clipped to a clipping threshold of $\pm 1$, and corresponding 4-fold interpolated signal values, generated by a subsequent device, or measured at the output of the subsequent device according to an example. Dashed arrows indicate clipped samples.

FIG. 1C shows a section of this digital input signal, clipped to a clipping threshold of $\pm 1$, and then amplitude limited to a

threshold of $\pm 1$ by the described method, and corresponding 4-fold interpolated signal values, generated by a subsequent device, or measured at the output of the subsequent device according to an example.

FIG. 2 shows the coefficients of a lowpass FIR filter (*LP*) used for interpolation according to an example.

FIG. 3A shows a block diagram of a 4-fold up-sampling stage and a 36-tap FIR filter "*LP*(1:36)", having filter coefficients numbered from 1 to 36, for interpolation according to an example.

FIG. 3B shows a block diagram (in polyphase structure) of four 9-tap FIR sub-filters (in parallel) used for up-sampling and interpolation according to an example.

FIG. 3C shows a block diagram of a clipping device, clipping a digital signal to a clipping threshold *ct* according to an example.

FIG. 4A shows a block diagram of two FIR filters with individual inputs and a common output.

FIG. 4B shows a block diagram of a single step limiting device configured to perform a single limiting step, the single step limiting device being configured to limit a digital signal to a limiting threshold *th,* depending on a weighting coefficient *w,* according to an example.

FIG. 4C shows a block diagram of a smoothing device, configured to perform a smoothing step, based on a digital bypass signal according to an example.

FIG. 4D shows a block diagram of an amplitude limiting device configured to perform a clipping step, a smoothing step and several limiting steps according to an example.

FIG. 5 shows a flow chart of a limiting step according to an example.

FIG. 6 shows a flow chart of an amplitude limiting method including a clipping step, a smoothing step and several limiting steps according to an example.

FIG. 7 shows a section of a frequency sweep digital signal, modified by an amplitude limiting method, with and without smoothing step, according to an example.

FIG. 8A shows a block diagram of an audio system according to an example.

FIG. 8B shows a block diagram of an audio system according to an example.

FIG. 8C shows a block diagram of an audio system according to an example.

## DETAILED DESCRIPTION

It should be noted that these figures are intended to illustrate the general characteristics of methods, circuitry or structures utilized in certain example embodiments and to supplement the written description provided below. These drawings should not be interpreted as defining or limiting the range of values or properties encompassed by example embodiments. The use of similar or identical reference numbers in the various drawings is intended to indicate the presence of a similar or identical element or feature.

Features and aspects of an amplitude limiting method and a corresponding amplitude limiting device will be disclosed by reference to the appended figures and taking a DAC as example of a subsequent device. The same principles are however applicable to other subsequent devices that may generate overshoot(s).

The subsequent device may be a band limiting and / or interpolating device. The subsequent device may be any device performing a frequency band limiting function, e.g., by means of a band limiting filter, for example a lowpass filter or a bandpass filter, or by executing an equivalent algorithm, or by circuitry performing band limiting. The subsequent device may also be an interpolating device that generates interpolated signal values between the samples of a digital input signal. Beside a band limiting filter, the band limiting or interpolating device may include signal processing circuitry that performs one or more further signal processing functions like up-sampling, interpolation, or DAC conversion.

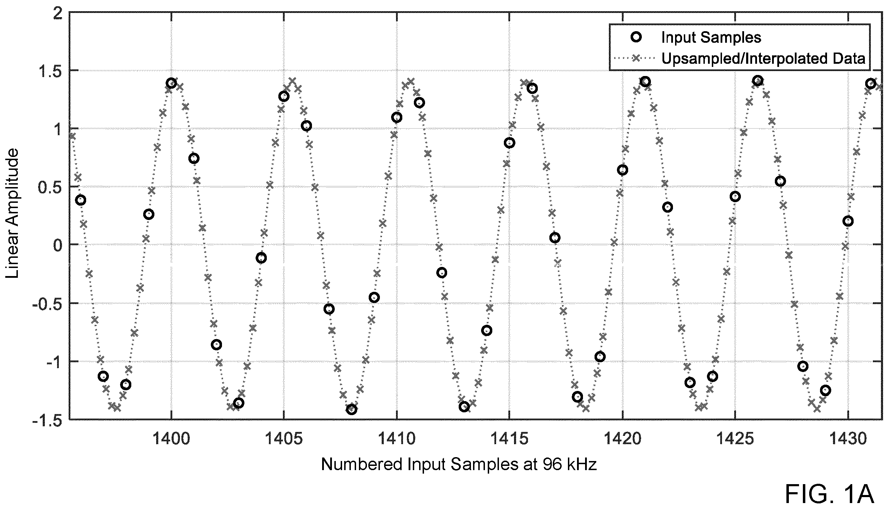

FIGS. 1A to 1C show the variations as a function of time of the linear (between $\pm\sqrt{2}$ ) amplitude of a digital input signal (here a frequency sweep sampled at 96 kHz), and a corresponding up-sampled and interpolated signal (at 384 kHz) generated by a subsequent device, or measured at the output of the subsequent device. In these examples, the subsequent device is a DAC performing up-sampling and interpolation followed by DAC conversion. In these figures, the input samples are represented by circles while the interpolated signal values are represented by crosses. The up-sampling and interpolation is performed with a ratio of 4, such that 4 interpolated signal values are generated for each input sample. Depending on the frequency and / or amplitude of the digital input signal, different situations may occur.

In FIG. 1A, the input samples and the interpolated signal values have an amplitude in the range between $-\sqrt{2}$ and $\sqrt{2}$. This amplitude range is chosen as an example for a digital input signal that is +3 dB above a given threshold of 0 dB, or *th* = 1. In this example, no amplitude overshoot occurs for the up-sampled and interpolated digital signal.

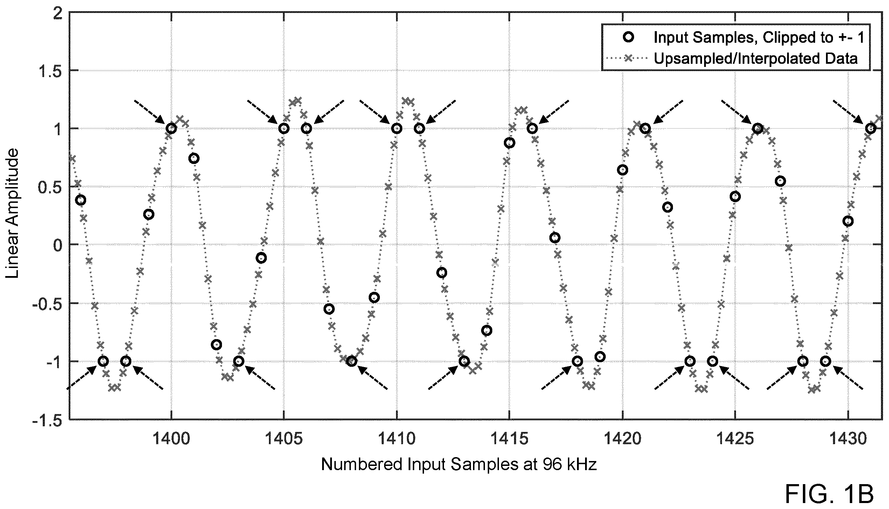

In FIG. 1B, the input samples are clipped to $\pm 1$ as indicated by the dashed arrows. Here no limiting according to the present description is applied. As can be seen, despite the clipping, the up-sampled and interpolated digital signal has sometimes a magnitude (an amplitude in absolute value) that is above 1, especially near (before / after) the clipped input samples.

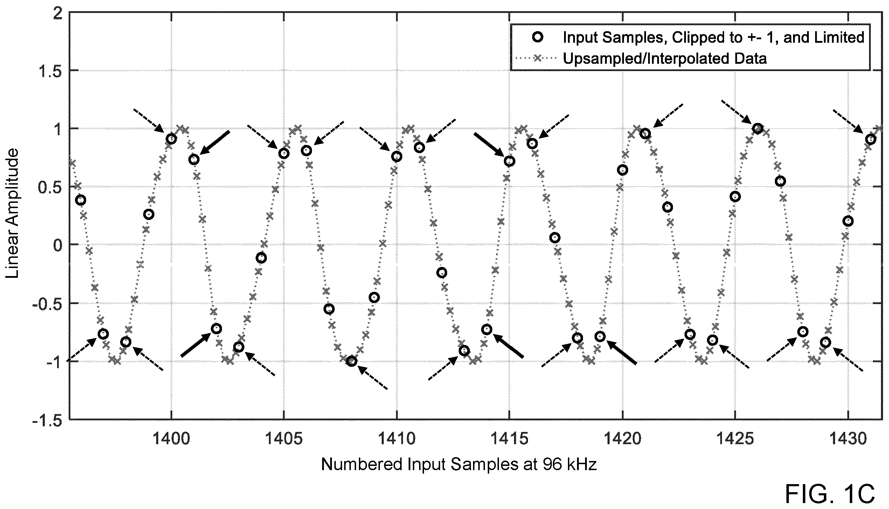

In FIG. 1C, the input samples are clipped to ±1, and then limited to ±1 as indicated by the dashed arrows and by the bold arrows. Dashed arrows indicate clipped and / or reduced samples. Bold arrows indicate additional reduced samples. The depicted samples have been processed by an amplitude limiting device according to the present description. As can be seen, the up-sampled and interpolated digital signal does not have a magnitude above 1.

It can be understood from these examples that, even when the samples are clipped to a maximum level, subsequent band limiting or interpolation (e.g., by an FIR filter of a DAC) may generate amplitude overshoot. This amplitude overshoot may cause signal distortions (or other unwanted effects) in downstream devices (e.g., a PWM amplifier) if such devices are connected to the output of the subsequent device performing band limiting or interpolation.

A signal processing system including an amplitude limiting device will be described in detail. The amplitude limiting device is introduced in a signal processing chain including a subsequent device (e.g., a band limiting or interpolating device). The subsequent device may include an interpolation filter (or comparable digital signal processing), or analog circuitry that performs a band limitation. The subsequent device may further include at least one of an up-sampling stage and a DAC.

The amplitude limiting device receives input samples to be processed by the subsequent device. The amplitude limiting device is configured to implement an amplitude limiting method that predicts signal values at the output of the subsequent device (e.g., generated in a subsequent device, as an analog or digital output of that subsequent device) and replaces input samples by reduced samples when an overshoot is detected. An input sample is replaced with a reduced sample by applying an offset to the concerned input sample. The reduced sample has the same sign, but a lower magnitude than the concerned input sample, i.e. the amplitude limiting method performs magnitude reduction. The prediction and limiting are performed by taking into account the effect on the amplitude of an output signal of a band limiting or interpolation filter implemented by the subsequent device to avoid lowering the magnitude of reduced samples more than necessary.

The amplitude limiting method uses a filter modelling the behavior of the subsequent device so as to estimate the behavior of the subsequent device and to perform the prediction of the overshoot. An overshoot difference may be determined between a threshold and a predicted output value at the output of the subsequent device, where the predicted output value is generated by applying the filter to a plurality of input samples.

The offset to be applied to an input sample may be computed based on parameters of the filter modelling the behavior of the subsequent device and the overshoot difference. For example, the parameters may include one or more coefficients (either the actual coefficients or estimated coefficients) of an interpolation filter used within the subsequent device. Alternatively, the parameters may include one or more samples from an impulse response (or derived from a step response) measured at the output of the subsequent device. These parameters may be used in analysis of the input samples to predict whether an overshoot (in absolute value) above a threshold may occur at the output of the subsequent device.

At least one limiting step is applied to the input samples. A detected overshoot for a predicted output signal means that a non-zero offset has been calculated. Such an offset (which may be weighted) is applied to one of the input samples contributing to the overshoot of the predicted output signal to generate a reduced sample (with lowered magnitude but the same sign, compared to the corresponding input sample). Reduced samples are fed to a subsequent device in a signal processing chain (including the subsequent device) in replacement of the input samples. The subsequent device may or not be the first subsequent device in the signal processing chain connected to the output of the amplitude limiting device.

Only one input sample may be limited among those that contribute to the overshoot. The input sample that is modified may be the sample that contributes the most to the overshoot.

The number of limiting steps may be equal to 2 or 3 or more. The limiting steps may be executed one after another, in a sequential manner. At least one smoothing step for correction of unwanted "notches" may be applied (for example after one of the limiting steps but before the last limiting step) to remove these notches introduced by the previous limiting step(s). For example, a first smoothing step may be applied after the first limiting step and before the second limiting step and a second smoothing step may be applied after the second limiting step and before the third (last) limiting step.

The amplitude limiting method requires a small amount of look-ahead. If the input samples are not known in advance, it may introduce additional latency between the input samples and the processed and / or reduced samples, depending on the number of limiting steps, the application of a smoothing step, the up-sampling factor, and / or the length of the applied interpolation filter. Given an integer up-sampling factor $M$, and a symmetric interpolation FIR filter $LP$ of length $N$, assuming $LP$ can be split into $M$ sub-filters of odd length $L = N/M$, the latency of each limiting step is $(L-1)/2$ samples. As an example with $M=4$, $N=36$, and $L=9$, each limiting step introduces 4 samples latency between input and output of block 600: An amplitude limiting method with 3 limiting steps (plus a smoothing step with 1 sample latency) adds a latency of $3.4+1 = 13$ samples.

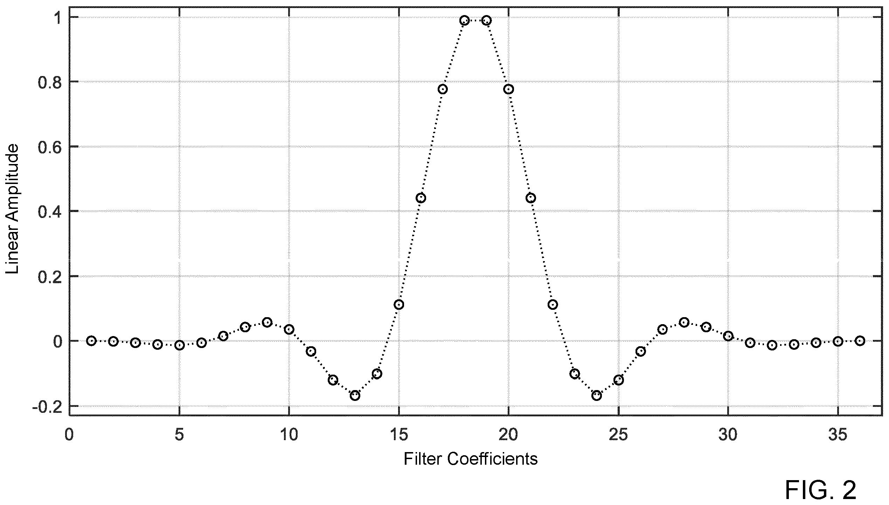

FIG. 2 shows the coefficients of an FIR filter that may be used for modelling the behavior of a subsequent device according to an example. If the subsequent device is a DAC, the FIR filter may be the interpolation filter used within the DAC. As illustrated by FIG. 2, the filter coefficients of the FIR filter may be taken from the impulse response (or derived from the step response) at the output of a filter for interpolation within a subsequent device, or by a similar measurement at the digital or analog output of that device. The interpolation filter may be modelled as a low pass FIR filter having a symmetric impulse response. In this example, a symmetric 36-tap prototype of the interpolation filter is derived from a step response measured at the output of a DAC.

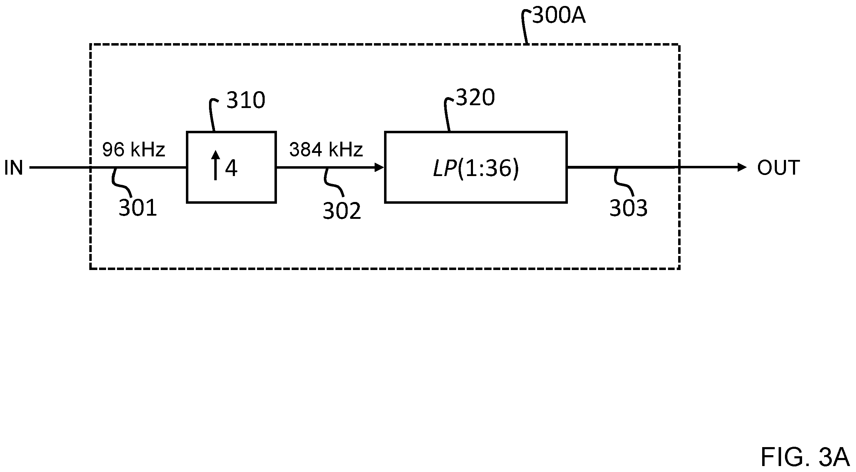

FIG. 3A shows a block diagram 300A of an FIR filter that may be used for modelling the behavior of a subsequent device according to an example. The subsequent device may be a device performing up-sampling and interpolation, like a DAC. A digital input signal 301 (e.g., a digital signal sampled at 96 kHz) is received. An up-sampling stage 310 is configured to up-sample the digital input signal (e.g., by a factor 4) by zero padding and to generate an up-sampled digital signal 302 (e.g., at 384 kHz). The up-sampling stage 310 is followed by an FIR filter 320 (lowpass, LP) configured to filter the up-sampled digital signal. Attenuating high-frequency content introduced by zero padding, the FIR filter 320 generates an interpolated digital signal 303 (e.g., at 384 kHz). In the example of FIG. 3A, the FIR filter 320 has $N$=36 coefficients. The digital output signal 303 is the result of a convolution between the up-sampled digital signal and the coefficients of FIR filter 320. If an adjustment of the output signal level is required, this can be realized for example by scaling the coefficients of FIR filter 320.

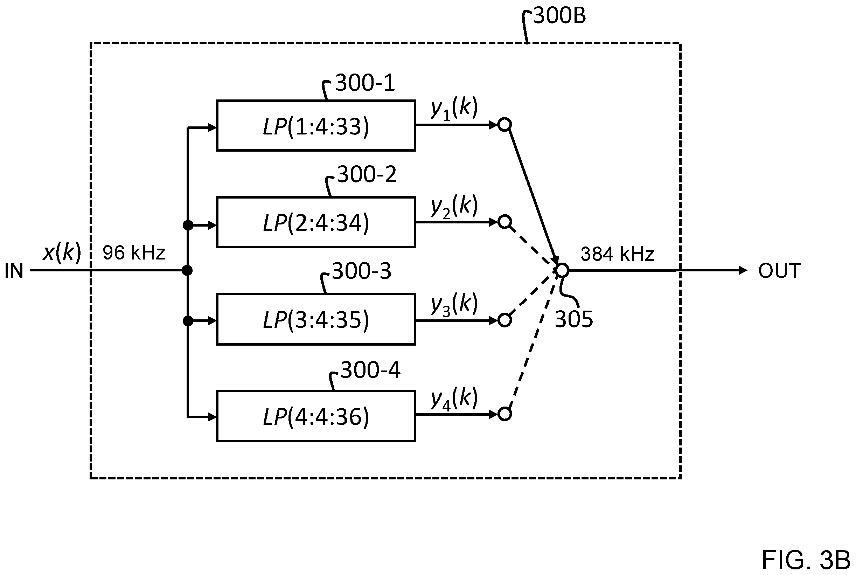

FIG. 3B shows a block diagram 300B of an FIR filter that may be used for modelling the behavior of a subsequent device according to an example. The subsequent device may be a device performing up-sampling and interpolation, like a DAC. In this example, the FIR filter has a polyphase structure and a length $N$=36. This FIR filter may be split into four parallel sub-filters 300-1 to 300-4 of length $L$=9 such that each sub-filter performs a convolution by applying a 9-tap FIR filter.

Let $x(k)$ be the samples of a digital input signal to be fed to the sub-filters 300-1 to 300-4. Here, $k$ denotes the index of the samples of a digital signal. The input samples may or may not have an amplitude clipped between positive and negative clipping threshold. Sub-filter 300-1 has filter coefficients numbered 1, 5, 9, 13, 17, 21, 25, 29, 33. For each sub-filter 300-1 to 300-4, the filter coefficients are numbered in ascending steps of 4.

With $n$ = 1...4, the sub-filters 300-1 to 300-4 are named *"LP(n:4:n+32)"*. The output values of the $n$-th sub-filter are given by

$$y_n(k) = \sum_{i=0}^{8} x(k - i) \cdot LP(4i + n) \qquad (Eq.\,1)$$

For each input sample $x(k)$, 4 individual output values are supplied in parallel by the 4 sub-filters. A selector stage 305 multiplexes all filter outputs $y_n(k)$ into a single signal, thus up-sampling by factor $M$=4 (e.g., from 96 kHz sample rate to 384 kHz) and generating the digital output signal of block diagram 300B. The implementation in FIG. 3B is designed to have the same functionality as the implementation in FIG. 3A. This shows that different models / designs may be used for the simulation of the behavior (and the prediction of overshoot) of a subsequent device.

Let *th* be the limiting threshold which relates to the maximum output magnitude of a subsequent device. The limiting threshold *th* may be equal to the clipping threshold *ct* used for clipping when the input samples are clipped samples. This limiting threshold *th* can be set by taking into account the maximum input voltage of one or more subsequent devices (e.g., the PWM amplifier or analog amplifier, etc.) following the amplitude limiting device in the signal processing chain. This limiting threshold *th is* a linear value (i.e., not a threshold given in dB).

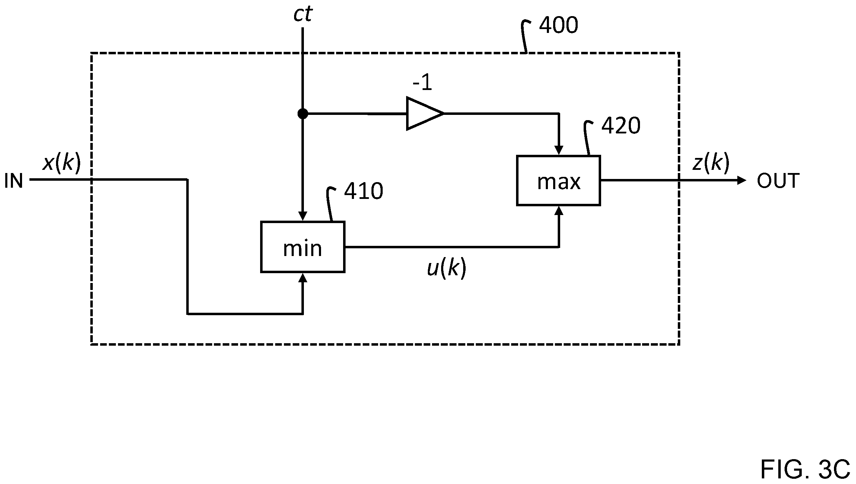

FIG. 3C shows a block diagram of a clipper 400 (also referred herein to as a clipping device 400). The clipper is configured to implement a clipping function by setting all input samples above a positive clipping threshold 410 to value *ct,*

$$u(k) = \min\{x(k), ct\}$$

and setting all input samples below a negative clipping threshold 420 to value *-ct,*

$$z(k) = \max\{u(k), -ct\}$$

Here, $x(k)$ are samples of the digital input signal, $u(k)$ are samples of an intermediate digital signal, and z(k) are samples of the digital output signal of clipping device 400.

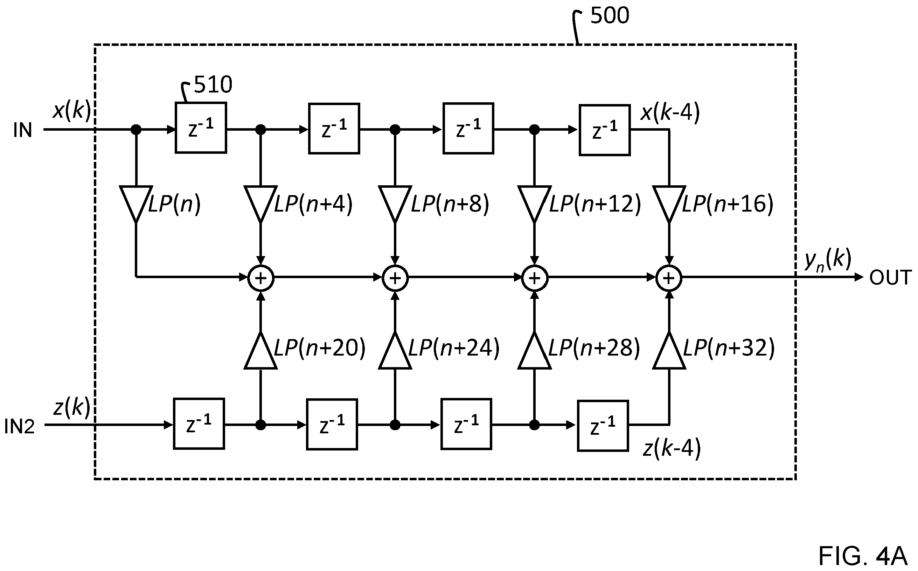

FIG. 4A shows a block diagram 500 of a filter that may be used for modelling the behavior of a subsequent device according to an example. In this example, the filter includes two parallel FIR filters: a 5-tap FIR filter with a digital input signal $x(k),$ and a 4-tap FIR filter with a second digital input signal z(k) and an initial delay of one sample. The outputs of both FIR filters are summed up to a digital output signal $y_n(k)$. It is an alternative to the sub-filters 300-1 to 300-4 depicted in FIG. 3B.

If the samples of the second digital input signal $z(k)$ depend on the first digital input signal $x(k)$ with $z(k) = x(k - 4)$, then block 500 operates like a 9-tap sub-filter $LP(n:4:32+n)$ for $n$=1...4, according to equation *Eq.* 1. If the samples of the second digital input signal $z(k)$ have arbitrary values, then

$$y_n(k) = \sum_{i=0}^{4} x(k-i) \cdot LP(4i+n) \ + \ \sum_{i=1}^{4} z(k-i) \cdot LP(4i+n+16) \qquad (Eq.\,2)$$

In a software implementation of this method, where the processor has read and write access to the delayed input samples $x(k-i)$, equation $Eq.\,2$ can be replaced by equation $Eq.\,1$ if the value of sample $x(k-4)$ is modified "in place" at each index $k$ by setting $x(k-4) = z(k)$ before proceeding to index $k+1$.

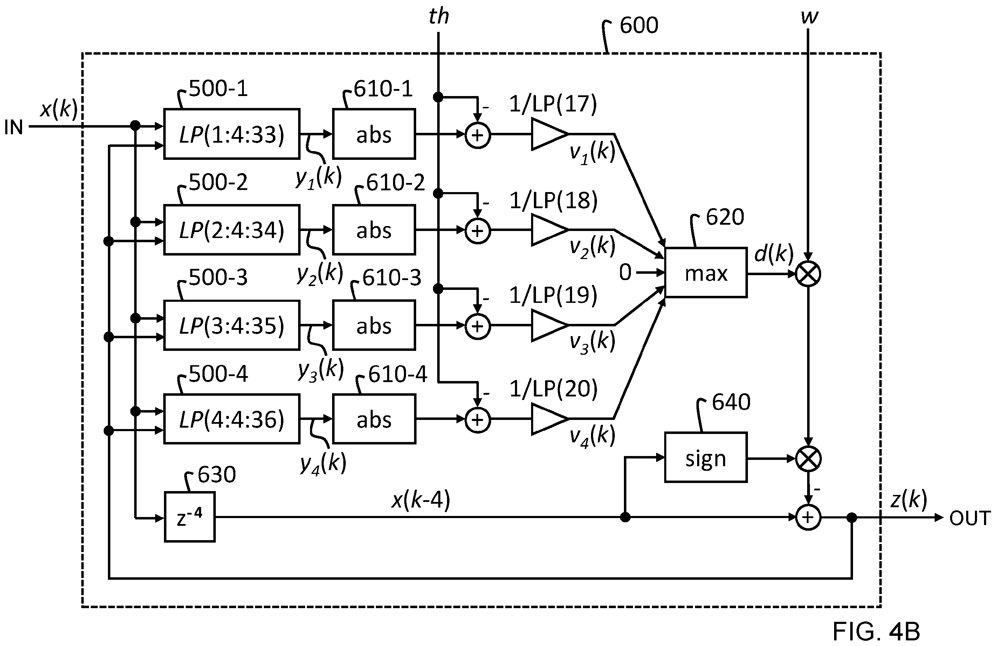

FIG. 4B shows a block diagram of a single step limiting device 600 configured to implement only one limiting step of the disclosed amplitude limiting method. This figure illustrates how parallel polyphase filters, each according to block diagram 500 of FIG. 4A, for $n=1...4$, may be used to model the behavior of a subsequent device, estimate and correct overshoot. Here, $x(k)$ are samples of the digital input signal, $y_n(k)$ and $v_n(k)$ and $d(k)$ are samples of different intermediate digital signals for $n=1...4$, and $z(k)$ are samples of the digital output signal of single step limiting device 600.

As shown in equation $Eq.\,2$, individual sub-filter output values $y_n(k)$ of the 4 FIR sub-filters 500-1 to 500-4 for $n=1...4$ are calculated from input samples $x(k)$ and from feedback samples $z(k)$ that correspond to output samples generated by the amplitude single step limiting device 600. Each sub-filter output $y_n(k)$ is used to determine an overshoot difference between a threshold $th$ and a predicted output value: $|y_n(k)|$ - $th$. Here the absolute values 610-1 to 610-4 of sub-filter outputs $y_n(k)$ are taken, and the limiting threshold $th$ is subtracted.

It is assumed in this example that in each sub-filter, the center coefficient $LP(16+n)$ with $i=4$ and $n=1...4$ has the largest magnitude. Thus, the corresponding input sample $x(k-4)$ to which this center coefficient is applied is the input sample that contributes the most to the overshoot difference for the respective sub-filter. Regarding convolution, reducing the magnitude of the corresponding input sample $x(k-4)$ has the biggest effect on a sub-filter output $y_n(k)$ for overshoot reduction. However, the adjacent sub-filter coefficients $LP(12+n)$ with $i=3$ and $n=1...4$, and $LP(20+n)$ with $i=5$ and $n=1...4$ may be negative. Keeping the magnitude of $y_n(k)$ below a threshold by reducing the magnitude of $x(k-4)$ can therefore increase the magnitude of the previous sub-filter output $y_n(k-1)$ and / or the next sub-filter output $y_n(k+1)$. This potential problem is addressed by cascading two or more single step limiting devices 600 performing each a single limiting step.

In this example, it is assumed that the center coefficient in each sub-filter has the largest magnitude. If the largest magnitude is located in another position, but the same position for most sub-filters or all sub-filters, selection index $LP(16+n)$ with $i=4$ and $n=1...4$ may be adjusted accordingly, as well the latency of delay block 630.

To scale each overshoot difference, the overshoot difference is multiplied by the reciprocal center coefficient, here $LP(16+n)$, of the applied sub-filter, $n = 1...4$:

$$v_n(k) = (|y_n(k)| - th) \cdot \frac{1}{LP(16+n)} \qquad (Eq.\,3)$$

From these scaled overshoot differences, the largest one is selected by a max function 620, and used as offset $d(k)$:

$$d(k) = \max\{v_n(k)\colon n = 0...4\} \qquad (Eq.\,4)$$

Here, an additional digital signal is defined as a "zero function":

$$v_0(k) = 0$$

The offset is always non-negative, because 0 is taken as an additional input argument to a max function 620.

When no sub-filters are used for the filter modeling the behavior of the subsequent device but only one filter, only one scaled overshoot difference is computed (e.g., based on the largest coefficient of the filter) and used as the offset $d(k)$ to reduce the input sample.

In some embodiments, a weighting coefficient w is applied to the offset in each limiting step to control the amount of limiting to be applied. The weighting coefficient w is in the range from 0 to 1, for example $w = 0.5, 0.6, 0.7, 0.75, 0.8, 0.85, 0.9, 0.95, 1$. The weighting coefficient may be the same for all samples processed during a limiting step but may vary from a limiting step to a next one. For example, for the first limiting step, the first weighting coefficient $w_1$ may be set between 0.5 and 0.75, while coefficients $w_2$, $w_3$, etc. are set to increasing values up to 1 for following limiting steps. In combination with a smoothing step, these weighting coefficients allow to avoid lowering the magnitude of reduced samples more than necessary.

In the example of FIG. 4B, the offset $d(k)$ is multiplied by a weighting coefficient $w$. Then this weighted offset is multiplied by the sign 640 of the time-aligned input sample $x(k-4)$. Time-alignment is realized with a delay block 630 of 4 samples, because calculating the sub-filter outputs $y_n(k)$ introduces 4 samples latency in each block 500-1 to 500-4.

Finally, the sign-corrected and weighted offset is subtracted from the time-aligned input sample $x(k - 4)$:

$$z(k) = x(k - 4) - \text{sign}\{x(k - 4)\} \cdot w \cdot d(k) \qquad (Eq.\,5)$$

The sign function can be defined as:

$$\text{sign}\{x\} = \begin{cases} 1 & if \quad x > 0 \\ -1 & if \quad x < 0 \end{cases}$$

Depending on the hardware and / or software platform, the function sign{0} may return 0 or 1. The herein described method works with both options.

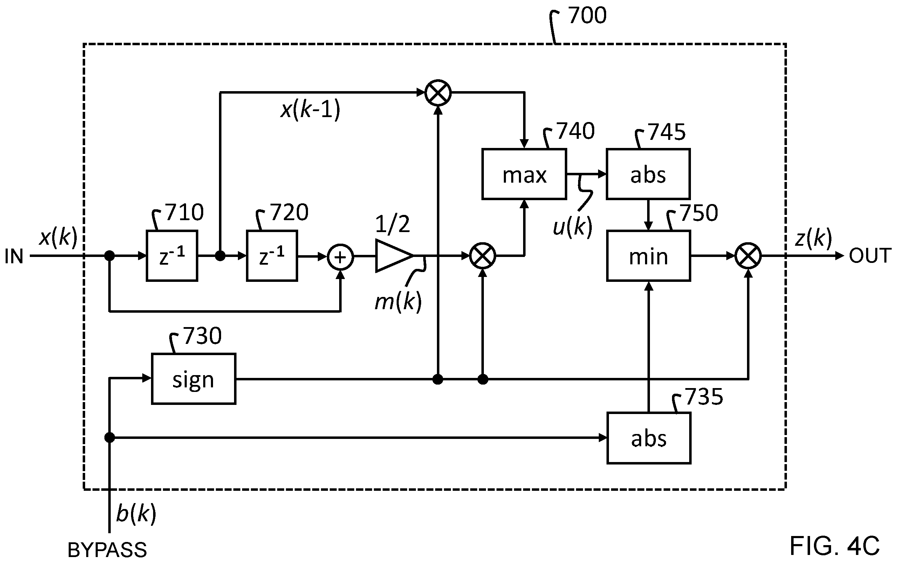

FIG. 4C shows a block diagram of a smoothing device 700 configured to implement an optional smoothing step as part of the disclosed amplitude limiting method. Here, $x(k)$ are samples of the digital input signal, $u(k)$ and $m(k)$ are samples of intermediate digital signals, $b(k)$ are samples of the digital bypass signal, and $z(k)$ are samples of the digital output signal of smoothing device 700.

Reduced samples (i.e., samples modified by one or more limiting steps 600) may be lower in magnitude than the previous and the next sample, thus creating an unwanted "notch" in the amplitude limited digital signal, i.e., adding high-frequency oscillations not being present in the digital input signal. The filter generating $m(k)$ may be implemented in several ways.

According to some embodiments, a comparison between the input samples and the reduced samples may be performed to determine whether a smoothing step has to be applied. It means that depending on a second digital signal named BYPASS or digital bypass signal (corresponding to delayed samples $b(k)$ without applied limiting steps), some of the input samples are replaced with the average (i.e., arithmetic mean or another filter) of their previous and the next sample:

$$m(k) = (x(k) + x(k - 2))/2 \qquad (Eq.\,6)$$

The sign function allows to handle positive as well as negative valued input samples and / or bypass samples in a combined calculation: the time-aligned 710 input sample $x(k - 1)$ and the averaged sample $m(k)$ are both multiplied by the sign 730 of the bypass sample $b(k)$. From these two, the greater value is taken by a max function 740:

$$u(k) = \max\{x(k - 1) \cdot \text{sign}\{b(k)\}, m(k) \cdot \text{sign}\{b(k)\}\} \qquad (Eq.\,7)$$

The magnitude 745 of sample $u(k)$ is compared to the magnitude 735 of the bypass sample $b(k)$, and the smaller value is taken by a min function 750 to ensure that a corrected output sample $z(k)$ cannot have a larger magnitude than the corresponding bypass sample $b(k)$. Finally, the result of min function 750 is multiplied by the sign of bypass sample $b(k)$:

$$z(k) = \min\{|u(k)|, |b(k)|\} \cdot \text{sign}\{b(k)\} \qquad (Eq.\,8)$$

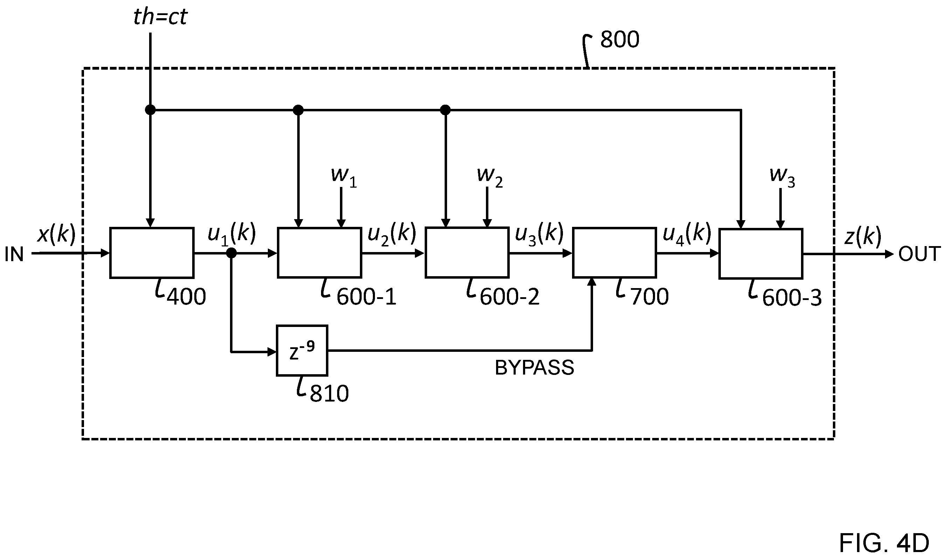

FIG. 4D shows a block diagram of an amplitude limiting device 800 implementing the disclosed amplitude limiting method with several limiting steps. Here the device 800 includes a clipping device 400, 3 single step limiting devices 600-1 to 600-3 for implementing 3 limiting steps, and a smoothing device 700. The clipping device may correspond to the clipping device 400 described by reference to FIG. 3C. Each of the single step limiting devices 600-1 to 600-3 may correspond to a limiting device 600 described by reference to FIG. 4B. The smoothing device may correspond to the smoothing device 700 described by reference to FIG. 4C.

After applying a clipping threshold $ct$ (by the clipping device 400) to input samples $x(k)$, two limiting steps are applied in a sequential manner. The two single step limiting devices 600-1 and 600-2 use the limiting threshold $th$, which may be equal to the clipping threshold $ct$, as well as a first weighting coefficient $w_1$ and a second weighting coefficient $w_2$. Followed by a smoothing step applied by the smoothing device 700, a time-aligned digital signal (using delay block 810) bypasses the two single step limiting devices 600-1 and 600-2, which serves as a digital bypass signal to the smoothing device 700. Time-alignment takes into account that each limiting step causes a 4-sample latency, and that a smoothing step causes a 1-sample latency. After smoothing device 700, a third single step limiting device 600-3 applies an additional limiting step, using a third weighting coefficient $w_3$. As an example, the first weighting coefficient $w_1$ can be set in the range 1/2 to 3/4, while second and third weighting coefficients $w_2$ and $w_3$ are set to 1. Assuming that clipping device 400 is latency-free, the complete amplitude limiting device 800 causes a 13-sample latency.

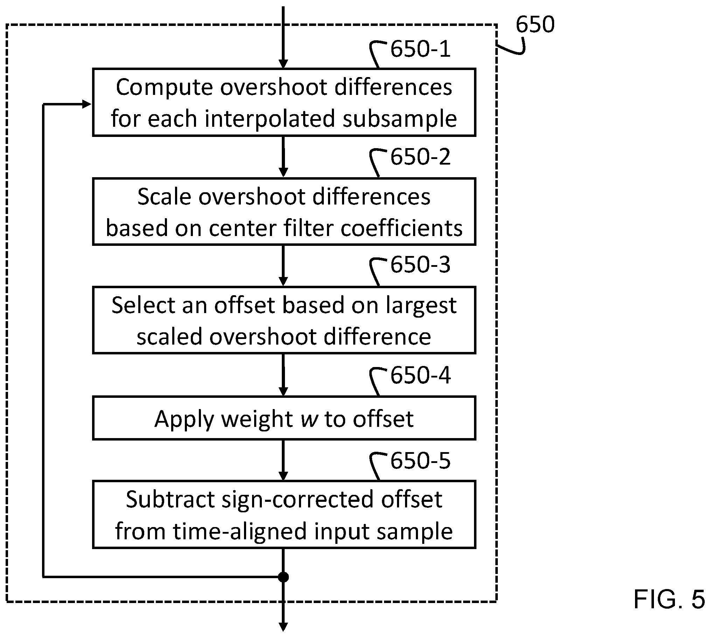

A limiting step 650 is illustrated by the flowchart of FIG. 5. The limiting step corresponds to the processing performed by the single step limiting device disclosed by reference to FIG. 4B.

At sub-step 650-1, overshoot differences $|y_n(k)| - th$ are computed from input samples $x(k)$. When parallel filters are used as disclosed by reference to FIGS. 4A and 4B, some output samples $z(k)$ at the output of the single step limiting device 600 are used as feedback samples and fed to the parallel filters 500-1 to 500-4. If a polyphase implementation is used, several overshoot differences are computed for a given time-aligned input sample $(k - 4)$, one overshoot difference being computed for each sub-filter.

At sub-step 650-2, each overshoot difference is scaled based on the largest filter coefficient of the concerned filter (or respective sub-filter) to compute a scaled overshoot difference $v_n(k)$. The above equation $Eq.$ 3 may be used for the computation of the scaled overshoot differences.

At sub-step 650-3, for a polyphase implementation of the filter modeling the behavior of the subsequent device, an offset $d(k)$ is selected as the largest scaled overshoot difference.

At sub-step 650-4, the selected offset $d(k)$ may be weighted based on a weighting coefficient $w$ as described for example by reference to FIGS. 4B or 4D. This step may be omitted if the weighting coefficient w is equal to 1.

At sub-step 650-5, a reduced input sample $z(k)$ is generated by subtracting the sign-corrected weighted offset from the time-aligned input sample $x(k - 4)$. The above equation $Eq.$ 5 may be used for the computation of $z(k)$.

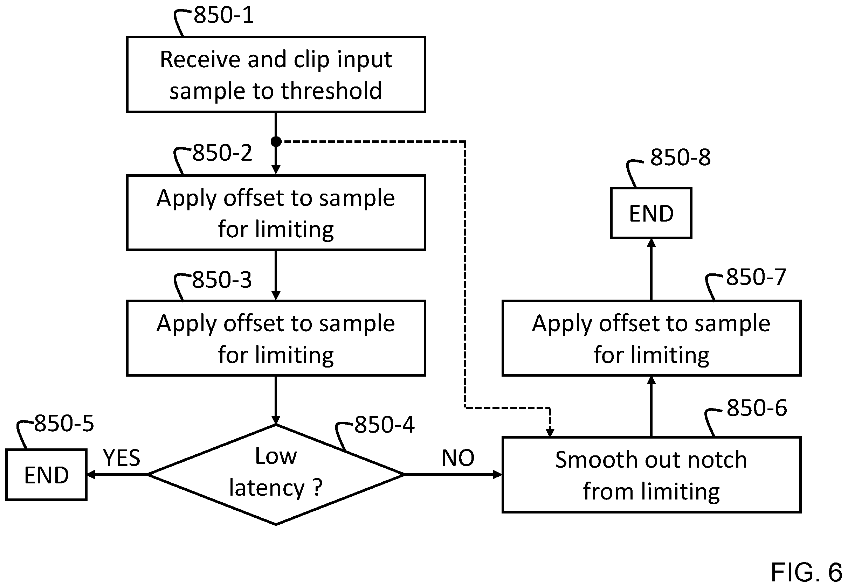

An amplitude limiting method is illustrated by the flowchart of FIG. 6. The amplitude limiting method corresponds to the processing performed by the device 800 disclosed by reference to FIG. 4D. This amplitude limiting method is executed for each input sample. The amplitude limiting method includes at least one limiting step and may include for example 2 or 3 limiting steps. It may include one or more smoothing steps, e.g. a smoothing step after at least one of the first and/or second limiting step, but before the last limiting step. It may include a clipping step before the first limiting step. An example embodiment is disclosed below.

At step 850-1 (clipping step), input samples of a signal to be processed by a subsequent device are received. The subsequent device may be a band limiting or interpolating device. Each input sample $x(k)$ may be clipped to a clipping threshold $ct$ to generate a clipped sample $u_1(k)$.

At step 850-2 (first limiting step) a limiting step is performed during which at least one input sample (clipped samples $u_1(k)$ or input samples $x(k)$ if no clipping step is performed) is replaced with a reduced sample $u_2(k)$ by applying an offset to the concerned input sample. The offset may be a weighted offset which is weighted with a weighting coefficient $w_1$ to generate a reduced sample $u_2(k)$. When no overshoot is detected (the overshoot difference is zero), no input sample is modified or, equivalently, an offset equal to zero is applied during the limiting step: in this case, the reduced sample $u_2(k)$ is equal to the time-aligned input sample $x(k - 4)$, or a clipped sample $u_1(k - 4)$ if step 850-1 is executed. Step 850-2 may be performed as disclosed by reference to FIG. 5 and / or FIG. 4B.

At step 850-3 (second limiting step), a limiting step is performed during which at least one input sample $u_2(k)$ is replaced with a reduced sample $u_3(k)$ by applying an offset to the concerned input sample. The offset may be a weighted offset which is weighted with a weighting coefficient $w_2$ to generate a reduced sample $u_3(k)$. When no overshoot is detected (the overshoot difference is zero), the reduced sample $u_3(k)$ is equal to the time-aligned input sample $u_2(k - 4)$. Step 850-3 may be performed as disclosed by reference to FIG. 5 and / or FIG. 4B.

At step 850-4, it is decided whether a low-latency version or an unabridged version (with smoothing step) of the method is applied. If a low-latency version is applied, then the method ends at step 850-5. If an unabridged version is applied, then step 850-6 is executed after step 850-4.

For example, for the filter coefficients of FIG. 2, it has been found by simulations that 3-step limiting sufficiently reduces overshoot. If a low-latency version is applied, the method can have 8 samples latency; otherwise, the method can have 13 samples latency. The total number of limiting steps may be adapted to the length and / or the transfer function of the interpolation filter.

At step 850-6, a smoothing step is applied to sample $u_3(k)$ obtained after the second limiting step 850-3 to generate a sample $u_4(k)$. The smoothing step may use the time-aligned sample $u_1(k - 9)$ for internal calculation. The smoothing step allows to remove notches introduced by any of the first and second limiting steps 850-2 and 850-3. This smoothing step may be performed as disclosed by reference to FIG. 4C. If no sample is modified during the smoothing step, the sample $u_4(k)$ is equal to the time-aligned sample $u_3(k - 1)$ obtained after the second limiting step 850-3.

At step 850-7 (third limiting step), a limiting step is performed during which at least one input sample $u_4(k)$ is replaced with a reduced sample $z(k)$ by applying an offset to the concerned input sample. The offset may be a weighted offset which is weighted with a weighting coefficient $w_3$ to generate the reduced sample $z(k)$. When no overshoot is detected (the overshoot difference is zero), the reduced sample $z(k)$ is equal to the time-aligned input sample $u_4(k - 4)$. Step 850-7 may be performed as disclosed by reference to FIG. 5 and 1 or FIG. 4B

The method ends at step 850-8 after step 850-7.

For each limiting step 850-2, 850-3 or 850-7, a reduced sample has the same sign, but a lower magnitude than the concerned input sample.

For each limiting step 850-2, 850-3 or 850-7, a filter modelling the behavior of the subsequent device is used for determining the offset to be applied. A predicted output value at the output of a subsequent device is generated by applying the filter to a plurality of corresponding (i.e; time aligned) input samples. An overshoot difference between a threshold *th* and the predicted output value is computed. The offset is computed based on the overshoot difference.

For each limiting step 850-2, 850-3 or 850-7, the plurality of input samples from which the predicted output value is generated includes the input sample to which the offset is applied such that reducing this input sample also reduces the overshoot difference computed for the concerned predicted output value.

For example, if the filter modelling the behavior of the subsequent device is modelled by a Finite Impulse Response filter, FIR filter, the parameters of the filter include the coefficients of the FIR filter. The offset may be computed based on the largest coefficient in absolute value of the FIR filter. The offset may be applied to the input sample to which the largest coefficient is applied in the FIR filter to generate the predicted output value.

For example, if the filter modelling the behavior of the subsequent device has a polyphase structure including parallel sub-filters, an overshoot difference is computed for each of the sub-filters, each overshoot difference being computed between the threshold and a respective output value generated by the concerned sub-filter, wherein the offset is computed based on the largest overshoot difference and the largest coefficient in absolute value of the sub-filter for which the largest overshoot difference is computed. The offset is applied to the input sample to which the largest coefficient is applied in the sub-filter for which the largest overshoot difference is computed.

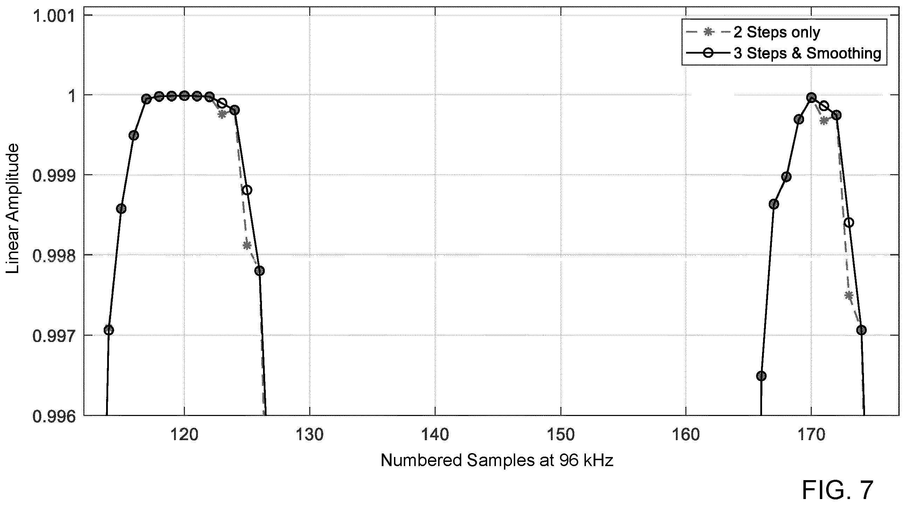

FIG. 7 shows a section of a digital signal after clipping and limiting by the disclosed amplitude limiting method, according to the flowchart of FIG. 6. Here, a low-latency version of the method with only two limiting steps and no smoothing step, and an unabridged version of the method with three limiting steps and a smoothing step are compared. Using the notation of FIG. 4D, samples $u_3(k)$ from the output of the low-latency version (clipped and 2-step limited) are depicted with grey asterisks. Samples $z(k)$ from the output of the unabridged version (clipped, 3-step limited, with smoothing step) are depicted with black circles. In this example, the first weighting coefficient $w_1$ is set to 3/4, while the second and third weighting coefficients $w_2$ and $w_3$ are set to 1. As can be seen, notches from 2-step limiting (low-latency version, see asterisks) can be sufficiently corrected by adding a smoothing step and a third limiting step.

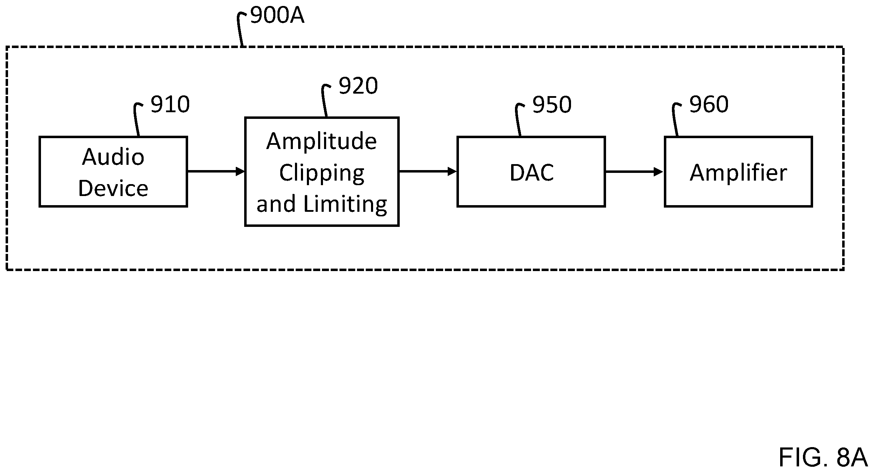

FIG. 8A shows a block diagram of an audio system 900A as a possible application of the disclosed amplitude limiting method. The audio system includes:

- an audio device 910 configured to generate input samples,
- a digital signal processor 920 (DSP) configured (e.g., with DSP code) to implement a clipping function (as disclosed for example by reference to FIG. 3C) and an amplitude limiting method as disclosed herein and to generate reduced samples replacing corresponding input samples when overshoot is predicted,
- a digital-to-analog converter (DAC) 950 to convert the input samples or reduced samples into an analog voltage for the subsequent audio amplifier 960,
- an audio amplifier (e.g., PWM amplifier) 960 configured to amplify the analog voltage generated by the DAC.

The amplitude limiting method implemented by the DSP 920 ensures that the analog output signal of a DAC 950 does not exceed an analog threshold which may be the digital threshold *th* depicted in FIG. 4D for the amplitude limiting device 800. This way, the amplifier 960 is protected from generating too high output voltage magnitudes.

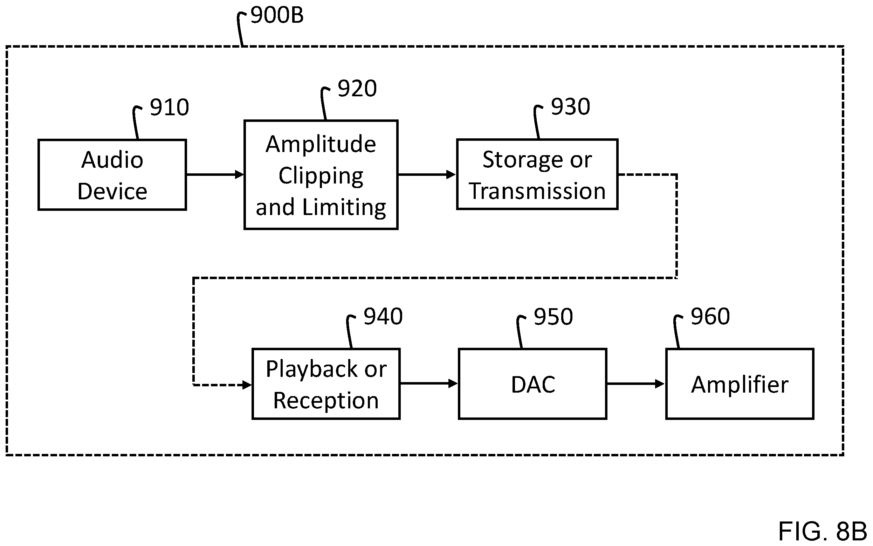

FIG. 8B shows an alternate block diagram of an audio system 900B as a possible application of the disclosed amplitude limiting method. The audio system includes:

- an audio device 910 configured to generate input samples,
- a digital signal processor 920 (DSP) configured (e.g., with DSP code) to implement a clipping function (as disclosed for example by reference to FIG. 3C) and an amplitude limiting method as disclosed herein and to generate reduced samples replacing corresponding input samples when overshoot is predicted,
- a digital data storage device 930 or a digital data transmission device 930,
- a playback device 940 retrieving digital data from a storage device, or a reception device receiving digital data from a transmission device,
- a digital-to-analog converter (DAC) 950 to convert the playback or received samples into an analog voltage for the subsequent audio amplifier 960,
- an audio amplifier (e.g., PWM amplifier) 960 configured to amplify the analog voltage generated by the DAC.

It can be seen that blocks 940, 950, and 960 are not required to be at the same location and / or time instant as DSP 920 while performing the disclosed amplitude limiting method. Thus, the amplitude limiting method performed by the DSP 920 may be implemented for example in a circuit physically separate from the circuit(s) including blocks 940, 950, and 960.

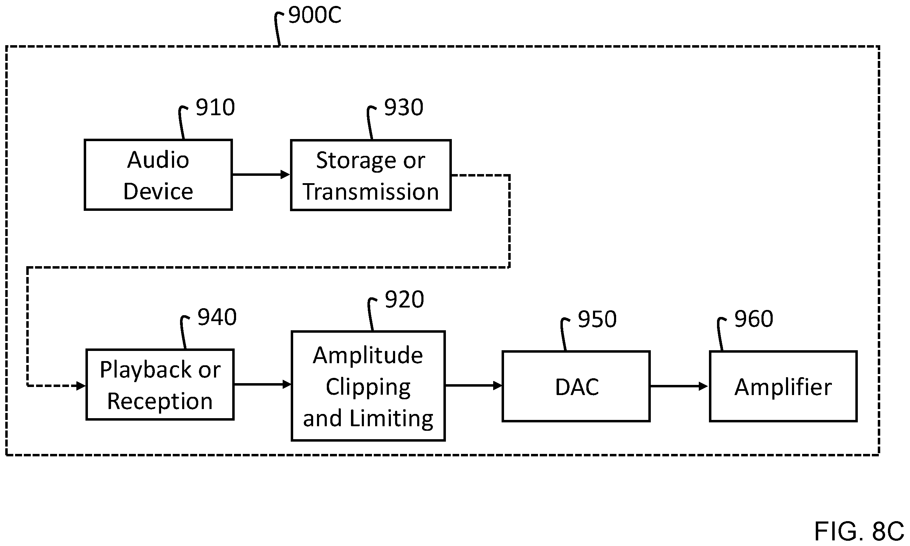

FIG. 8C shows an alternate block diagram of an audio system 900C as a possible application of the disclosed amplitude limiting method. Compared to FIG. 8B, the insertion of a block 930 in combination with a block 940 can be realized at a different position of the signal processing chain. In this example, it can be seen that blocks 910 and 930 are not required at the location of the DSP 920 or at runtime of the amplitude limiting method 920 to perform the disclosed amplitude limiting method.

It should be appreciated by those skilled in the art that any functions, engines, block diagrams, flow diagrams, state transition diagrams, flowchart and / or data structures described herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processing apparatus, whether or not such computer or processor is explicitly shown.

Although a flow chart may describe operations as a sequential process, many of the operations may be performed in parallel, concurrently, or simultaneously. Also, some operations may be omitted, combined, or performed in a different order. A process may be terminated when its operations are completed but may also have additional steps not disclosed in the figure or description. A process may correspond to a method, function, procedure, subroutine, subprogram, etc. When a process corresponds to a function, its termination may correspond to a return of the function to the calling function or the main function.

Each described function, engine, block, step described herein can be implemented in hardware, software, firmware, middleware, microcode, or any suitable combination thereof.

In the present description, the wording "means for performing a function" or "means configured to perform a function" may correspond to one or more functional blocks comprising circuitry that is adapted for performing or configured to perform this function. The block may perform itself this function or may cooperate and / or communicate with other one or more blocks to perform this function. The "means" may correspond to or be implemented as "one or more modules", "one or more devices", "one or more units", etc. The means may include at least one processor, at least one memory storing instructions configured to cause a target device / system to perform the concerned function.

The amplitude limiting device may be implemented by software and / or hardware.

When implemented in software, the amplitude limiting device may be implemented by circuitry (e.g., one or more circuits). Several types of circuitries may be used: digital signal processor (DSP) hardware, processor or microprocessor, application specific integrated circuit (ASIC), field programmable gate array (FPGA), etc. The circuitry may be or include, for example, hardware, programmable logic, a programmable processor that executes software or firmware, and / or any combination thereof (e.g., a processor, control unit / entity, controller) to execute instructions or software and control transmission and receptions of signals, and a memory to store data and / or instructions.

When implemented in software, firmware, middleware or microcode, instructions to perform the necessary tasks may be stored in a computer readable medium that may be or not be included in a target device or system. The instructions may be transmitted over the computer-readable medium and be loaded onto the target device or system. The instructions are configured to cause the target device / system to perform one or more functions disclosed herein. For example, as mentioned above, according to one or more examples, at least one memory may include or store instructions, the at least one memory and the instructions may be configured to, with at least one processor, cause the target device / system to perform the one or more functions. Additionally, the processor, memory, and instructions, serve as means for providing or causing performance by the target device / system of one or more functions disclosed herein.

The instructions may correspond to computer program instructions, computer program code and may include one or more code segments. A code segment may represent a procedure, function, subprogram, program, routine, subroutine, module, software package, class, or any combination of instructions, data structures or program statements.

When provided by a processor, the functions may be provided by a single dedicated processor, by a single shared processor, or by a plurality of individual processors, some of which may be shared. The term "processor" should not be construed to refer exclusively to hardware capable of executing software and may implicitly include one or more processing circuits, whether programmable or not. A processing circuit may correspond to a digital signal processor (DSP), a network processor, an application specific integrated circuit (ASIC), a field programmable gate array (FPGA), a System-on-Chips (SoC), a Central Processing Unit (CPU), a Processing Unit (CPU), an arithmetic logic unit (ALU), a programmable logic unit (PLU), a processing core, a programmable logic, a microprocessor, a controller, a microcontroller, a microcomputer, any device capable of responding to and / or executing instructions in a defined manner and / or according to a defined logic. Other hardware, conventional or custom, may also be included. A processor may be configured to execute instructions adapted for causing the performance by a target device or system of one or more functions disclosed herein for the concerned device or system.

A computer readable medium or computer readable storage medium may be any storage medium suitable for storing instructions readable by a computer or a processor. A computer readable medium may be more generally any storage medium capable of storing and / or containing and / or carrying instructions and / or data. A computer-readable medium may be a portable or fixed storage medium. A computer readable medium may include one or more storage device like a permanent mass storage device, magnetic storage medium, optical storage medium, digital storage disc (CD-ROM, DVD, Blue Ray, etc.), USB key or dongle or peripheral, memory card, random access memory (RAM), read only memory (ROM), core memory, flash memory, or any other non-volatile storage.

A memory suitable for storing instructions may be a random-access memory (RAM), read only memory (ROM), and / or a permanent mass storage device, such as a disk drive, memory card, random access memory (RAM), read only memory (ROM), core memory, flash memory, or any other non-volatile storage.

Although the terms first, second, etc. may be used herein to describe various elements, these elements should not be limited by these terms. These terms are only used to distinguish one element from another. For example, a first element could be termed a second element, and similarly, a second element could be termed a first element, without departing from the scope of this disclosure. As used herein, the term "and / or," includes any and all combinations of one or more of the associated listed items.

When an element is referred to as being "connected" or "coupled" to another element, it can be directly connected or coupled to the other element or intervening elements may be present. By contrast, when an element is referred to as being "directly connected" or "directly coupled" to another element, there are no intervening elements present. Other words used to describe the relationship between elements should be interpreted in a like fashion (e.g., "between," versus "directly between," "adjacent," versus "directly adjacent," etc.).

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and / or "including," when used herein, specify the presence of stated features, integers, steps, operations, elements, and / or components, but do not preclude the presence or addition of one or more other features, integers, steps, operations, elements, components, and / or groups thereof.

Specific details are provided in the following description to provide a thorough understanding of some examples. However, it will be understood by one of ordinary skill in the art that example embodiments may be practiced without these specific details disclosed for illustrative purposes. For example, systems may be shown in block diagrams so as not to obscure the examples in unnecessary detail. In other instances, well-known processes, structures, and techniques may be shown without unnecessary detail in order to avoid obscuring the examples.

Benefits, other advantages, and solutions to problems have been described above with regard to specific embodiments of the invention. However, the benefits, advantages, solutions to problems, and any element(s) that may cause or result in such benefits, advantages, or solutions, or cause such benefits, advantages, or solutions to become more pronounced are not to be construed as a critical, required, or essential feature or element of the invention.

**Claims**

1. A device (600, 800, 920) comprising signal processing means for performing a method comprising:

   - receiving (850-1) input samples of a signal to be processed by a subsequent device, wherein the absolute values of the input samples are equal to or below a clipping threshold;
   - performing a limiting step (850-2) on at least one input sample;
   wherein the limiting step comprises:

   - generating predicted intersample values by applying sub-filters to corresponding pluralities of input samples including the concerned input sample, wherein the sub-filters model the intersample behavior of the subsequent device; and
   - replacing the concerned input sample with a reduced sample by applying an offset to the concerned input sample,

   wherein the reduced sample has the same sign, but a lower magnitude than the concerned input sample, wherein the offset is computed based on parameters of the sub-filters and an overshoot difference between the clipping threshold and a predicted intersample value.

2. The device (600, 800, 920) of claim 1, wherein said parameters include actual or estimated coefficients of an interpolation filter within the subsequent device.

3. The device (600, 800, 920) of claim 1, wherein said parameters include parameters of an actual or estimated impulse response of the subsequent device.

4. The device (600, 800, 920) of any of claims 1 to 3, wherein the sub-filters modelling the behavior of the subsequent device are sub-filters of a Finite Impulse Response filter, FIR filter, wherein said parameters include coefficients of the FIR filter.

**5.** The device (600, 800, 920) of any of claims 1 to 4,

wherein the method includes computing a scaled overshoot difference for each of the sub-filters, each scaled overshoot difference being computed based on an overshoot difference between the clipping threshold and a respective predicted intersample value generated by the concerned sub-filter,

wherein the offset is computed based on the largest scaled overshoot difference.

**6.** The device (600, 800, 920) of claim 5,

wherein the offset is computed based on the largest coefficient in absolute value of the sub-filter for which the largest scaled overshoot difference is computed, wherein the offset is applied to the input sample to which the largest coefficient is applied in the sub-filter for which the largest scaled overshoot difference is computed;

wherein the scaled overshoot difference is scaled based on the largest coefficient in absolute value of the sub-filter for which the largest scaled overshoot difference is computed.

**7.** The device (600, 800, 920) according to any of the preceding claims, wherein the offset is computed based on a weighting coefficient in said limiting step.

**8.** The device (800, 920) according to any of the preceding claims, wherein the method includes performing a plurality of limiting steps (850-2, 850-3, 850-7) in a sequential manner, the plurality of limiting steps including said limiting step (850-2) and at least one further limiting step (850-3, 850-7),

wherein each further limiting step (850-3, 850-7) is applied to intermediate samples, wherein intermediate samples are samples that have been processed by the previous limiting step,

wherein each further limiting step (850-3, 850-7) comprises for each of at least one intermediate sample replacing the concerned intermediate sample with a reduced sample by applying a current offset to the concerned intermediate sample,

wherein the reduced sample has the same sign, but a lower magnitude than the concerned intermediate sample, wherein the current offset is computed based on the parameters of the sub-filters and a current overshoot difference between the clipping threshold and a current predicted intersample value generated by applying one of the sub-filters to a plurality of intermediate samples that have been processed by the previous limiting step.

**9.** The device (800, 920) according to claim 8, wherein the plurality of limiting steps include a last limiting step (850-7), wherein the method includes applying at least one smoothing step, each of the at least one smoothing step (850-6) being applied after one of the limiting steps but before the last limiting step (850-7).

**10.** A device (800, 920) according to any of the preceding claims, wherein the subsequent device is a band limiting or interpolating device.

**11.** The device (800, 920) according to any of the preceding claims, wherein the subsequent device is an interpolation filter of a Digital to Analog Converter, DAC.

**12.** The device (800, 920) according to any of the preceding claims, wherein the signal processing means comprise circuitry configured to perform at least one step of the method.

**13.** The device (800, 920) according to any of the preceding claims, wherein the signal processing means comprise at least one processor and at least one memory including computer program instructions, wherein the at least one memory and the computer program instructions are configured to, with the at least one processor, cause the device to perform at least one step of the method.

**14.** A method comprising

- receiving (850-1) input samples of a signal to be processed by a subsequent device, wherein the absolute values of the input samples are equal to or below a clipping threshold;
- performing a limiting step (850-2) on at least one input sample;
wherein the limiting step comprises:

- generating predicted intersample values by applying sub-filters to corresponding pluralities of input samples including the concerned input sample, wherein the sub-filters model the intersample behavior of the subsequent device; and
- replacing the concerned input sample with a reduced sample by applying an offset to the concerned input sample,

wherein the reduced sample has the same sign, but a lower magnitude than the concerned input sample, wherein the offset is computed based on parameters of the sub-filters and an overshoot difference between the clipping threshold and a predicted intersample value.

15. A computer program comprising instructions that, when executed by at least one processor, causes a device to perform a method as claimed in claim 14.

**Patentansprüche**

1. Vorrichtung (600, 800, 920), umfassend Signalverarbeitungsmittel zum Durchführen eines Verfahrens, umfassend:

- Empfangen (850-1) von Eingangssamples eines Signals, das durch eine nachfolgende Vorrichtung verarbeitet werden soll, wobei die Absolutwerte der Eingangssamples gleich oder unterhalb einer Clipping-Schwelle sind;
- Durchführen eines Begrenzungsschritts (850-2) an mindestens einem Eingangssample;
wobei der Begrenzungsschritt umfasst:

- Erzeugen vorhergesagter Intersample-Werte durch Anwenden von Teilfiltern auf entsprechende Vielzahlen von Eingangssamples einschließlich des betreffenden Eingangssamples, wobei die Teilfilter das Intersample-Verhalten der nachfolgenden Vorrichtung modellieren; und
- Ersetzen des betreffenden Eingangssamples durch ein reduziertes Sample durch Anwenden eines Offsets auf das betreffende Eingangssample,

wobei das reduzierte Sample das gleiche Vorzeichen, aber eine geringere Größe als das betreffende Eingangssample aufweist,
wobei der Offset basierend auf Parametern der Teilfilter und einer Überschwingungsdifferenz zwischen der Clipping-Schwelle und einem vorhergesagten Intersample-Wert berechnet wird.

2. Vorrichtung (600, 800, 920) nach Anspruch 1, wobei die Parameter tatsächliche oder geschätzte Koeffizienten eines Interpolationsfilters innerhalb der nachfolgenden Vorrichtung einschließen.

3. Vorrichtung (600, 800, 920) nach Anspruch 1, wobei die Parameter Parameter einer tatsächlichen oder geschätzten Impulsantwort der nachfolgenden Vorrichtung einschließen.

4. Vorrichtung (600, 800, 920) nach einem der Ansprüche 1 bis 3, wobei die Teilfilter, die das Verhalten der nachfolgenden Vorrichtung modellieren, Teilfilter eines Finite-Impulse-Response-Filters, FIR-Filters, sind, wobei die Parameter Koeffizienten des FIR-Filters einschließen.

5. Vorrichtung (600, 800, 920) nach einem der Ansprüche 1 bis 4,

wobei das Verfahren das Berechnen einer skalierten Überschwingungsdifferenz für jeden der Teilfilter einschließt, wobei jede skalierte Überschwingungsdifferenz basierend auf einer Überschwingungsdifferenz zwischen der Clipping-Schwelle und einem jeweiligen vorhergesagten Intersample-Wert, der durch den betreffenden Teilfilter erzeugt wird, berechnet wird,
wobei der Offset basierend auf der größten skalierten Überschwingungsdifferenz berechnet wird.

6. Vorrichtung (600, 800, 920) nach Anspruch 5,

wobei der Offset basierend auf dem größten Koeffizienten im Absolutwert des Teilfilters berechnet wird, für den die größte skalierte Überschwingungsdifferenz berechnet wird, wobei der Offset auf das Eingangssample angewendet wird, auf das der größte Koeffizient in dem Teilfilter angewendet wird, für den die größte skalierte Überschwingungsdifferenz berechnet wird;
wobei die skalierte Überschwingungsdifferenz basierend auf dem größten Koeffizienten im Absolutwert des Teilfilters skaliert wird, für den die größte skalierte Überschwingungsdifferenz berechnet wird.

7. Vorrichtung (600, 800, 920) nach einem der vorstehenden Ansprüche, wobei der Offset basierend auf einem Gewichtungskoeffizienten in dem Begrenzungsschritt berechnet wird.

8. Vorrichtung (800, 920) nach einem der vorstehenden Ansprüche, wobei das Verfahren das Durchführen einer Vielzahl von Begrenzungsschritten (850-2, 850-3, 850-7) in sequenzieller Weise einschließt, wobei die Vielzahl von Begrenzungsschritten den Begrenzungsschritt (850-2) und mindestens einen weiteren Begrenzungsschritt (850-3, 850-7) einschließt,

wobei jeder weitere Begrenzungsschritt (850-3, 850-7) auf Zwischensamples angewendet wird, wobei Zwischensamples Samples sind, die durch den vorherigen Begrenzungsschritt verarbeitet wurden, wobei jeder weitere Begrenzungsschritt (850-3, 850-7) für jedes von mindestens einem Zwischensample das Ersetzen des betreffenden Zwischensamples durch ein reduziertes Sample durch Anwenden eines aktuellen Offsets auf das betreffende Zwischensample umfasst, wobei das reduzierte Sample das gleiche Vorzeichen, aber eine geringere Größe als das betreffende Zwischensample aufweist, wobei der aktuelle Offset basierend auf den Parametern der Teilfilter und einer aktuellen Überschwingungsdifferenz zwischen der Clipping-Schwelle und einem aktuellen vorhergesagten Intersample-Wert berechnet wird, der durch Anwenden eines der Teilfilter auf eine Vielzahl von Zwischensamples erzeugt wird, die durch den vorherigen Begrenzungsschritt verarbeitet wurden.

9. Vorrichtung (800, 920) nach Anspruch 8, wobei die Vielzahl von Begrenzungsschritten einen letzten Begrenzungsschritt (850-7) einschließen, wobei das Verfahren das Anwenden mindestens eines Glättungsschritts einschließt, wobei jeder des mindestens einen Glättungsschritts (850-6) nach einem der Begrenzungsschritte, aber vor dem letzten Begrenzungsschritt (850-7) angewendet wird.

10. Vorrichtung (800, 920) nach einem der vorstehenden Ansprüche, wobei die nachfolgende Vorrichtung eine bandbegrenzende oder interpolierende Vorrichtung ist.

11. Vorrichtung (800, 920) nach einem der vorstehenden Ansprüche, wobei die nachfolgende Vorrichtung ein Interpolationsfilter eines Digital-Analog-Wandlers, DAC, ist.

12. Vorrichtung (800, 920) nach einem der vorstehenden Ansprüche, wobei die Signalverarbeitungsmittel Schaltlogik umfassen, die konfiguriert ist, um mindestens einen Schritt des Verfahrens durchzuführen.

13. Vorrichtung (800, 920) nach einem der vorstehenden Ansprüche, wobei die Signalverarbeitungsmittel mindestens einen Prozessor und mindestens einen Speicher einschließlich Computerprogrammanweisungen umfassen, wobei der mindestens eine Speicher und die Computerprogrammanweisungen konfiguriert sind, um mit dem mindestens einen Prozessor die Vorrichtung zu veranlassen, mindestens einen Schritt des Verfahrens durchzuführen.

14. Verfahren, umfassend:

- Empfangen (850-1) von Eingangssamples eines Signals, das durch eine nachfolgende Vorrichtung verarbeitet werden soll, wobei die Absolutwerte der Eingangssamples gleich oder unterhalb einer Clipping-Schwelle sind;
- Durchführen eines Begrenzungsschritts (850-2) an mindestens einem Eingangssample;
wobei der Begrenzungsschritt umfasst:

- Erzeugen vorhergesagter Intersample-Werte durch Anwenden von Teilfiltern auf entsprechende Vielzahlen von Eingangssamples einschließlich des betreffenden Eingangssamples, wobei die Teilfilter das Intersample-Verhalten der nachfolgenden Vorrichtung modellieren; und
- Ersetzen des betreffenden Eingangssamples durch ein reduziertes Sample durch Anwenden eines Offsets auf das betreffende Eingangssample,

wobei das reduzierte Sample das gleiche Vorzeichen, aber eine geringere Größe als das betreffende Eingangssample aufweist, wobei der Offset basierend auf Parametern der Teilfilter und einer Überschwingungsdifferenz zwischen der Clipping-Schwelle und einem vorhergesagten Intersample-Wert berechnet wird.

15. Computerprogramm, umfassend Anweisungen, die, wenn sie durch mindestens einen Prozessor ausgeführt werden, eine Vorrichtung veranlassen, ein Verfahren nach Anspruch 14 durchzuführen.

**Revendications**

1. Dispositif (600, 800, 920) comprenant des moyens de traitement de signal pour exécuter un procédé comprenant :

   - une réception (850-1) d'échantillons d'entrée d'un signal à traiter par un dispositif suivant, dans lequel les valeurs absolues des échantillons d'entrée sont égales ou inférieures à un seuil d'écrêtage ;
   - une exécution d'une étape de limitation (850-2) sur au moins un échantillon d'entrée ;
   dans lequel l'étape de limitation comprend :

      - une génération des valeurs inter-échantillons prédites par application de sous-filtres à des pluralités correspondantes d'échantillons d'entrée incluant l'échantillon d'entrée concerné, dans lequel les sous-filtres modélisent le comportement inter-échantillons du dispositif suivant ; et
      - un remplacement de l'échantillon d'entrée concerné par un échantillon réduit en appliquant un offset à l'échantillon d'entrée concerné,

   dans lequel l'échantillon réduit a le même signe, mais une magnitude inférieure à celle de l'échantillon d'entrée concerné,
   dans lequel l'offset est calculé sur la base de paramètres des sous-filtres et d'une différence de dépassement entre le seuil d'écrêtage et une valeur inter-échantillons prédite.

2. Dispositif (600, 800, 920) selon la revendication 1, dans lequel lesdits paramètres comportent des coefficients réels ou estimés d'un filtre d'interpolation dans le dispositif suivant.

3. Dispositif (600, 800, 920) selon la revendication 1, dans lequel lesdits paramètres comportent des paramètres d'une réponse impulsionnelle réelle ou estimée du dispositif suivant.

4. Dispositif (600, 800, 920) selon l'une quelconque des revendications 1 à 3, dans lequel les sous-filtres modélisant le comportement du dispositif suivant sont des sous-filtres d'un filtre à réponse impulsionnelle finie, FIR, dans lequel lesdits paramètres comportent des coefficients du filtre FIR.

5. Dispositif (600, 800, 920) selon l'une quelconque des revendications 1 à 4,

   dans lequel le procédé comporte un calcul d'une différence de dépassement mise à l'échelle pour chacun des sous-filtres, chaque différence de dépassement mise à l'échelle étant calculée sur la base d'une différence de dépassement entre le seuil d'écrêtage et une valeur inter-échantillons prédite respective générée par le sous-filtre concerné,
   dans lequel l'offset est calculé sur la base de la plus grande différence de dépassement mise à l'échelle.

6. Dispositif (600, 800, 920) selon la revendication 5,

   dans lequel l'offset est calculé sur la base du coefficient le plus élevé en valeur absolue du sous-filtre pour lequel la plus grande différence de dépassement mise à l'échelle est calculée, dans lequel l'offset est appliqué à l'échantillon d'entrée auquel le coefficient le plus élevé est appliqué dans le sous-filtre pour lequel la différence de dépassement mise à l'échelle la plus importante est calculée ;
   dans lequel la différence de dépassement mise à l'échelle est mise à l'échelle sur la base du coefficient le plus élevé en valeur absolue du sous-filtre pour lequel la différence de dépassement mise à l'échelle la plus grande est calculée.

7. Dispositif (600, 800, 920) selon l'une quelconque des revendications précédentes, dans lequel l'offset est calculé sur la base d'un coefficient de pondération dans ladite étape de limitation.

8. Dispositif (800, 920) selon l'une quelconque des revendications précédentes, dans lequel le procédé comporte une exécution d'une pluralité d'étapes de limitation (850-2, 850-3, 850-7) d'une manière séquentielle, la pluralité d'étapes de limitation comportant ladite étape de limitation (850-2) et au moins une autre étape de limitation (850-3, 850-7),

dans lequel chaque étape de limitation supplémentaire (850-3, 850-7) est appliquée à des échantillons intermédiaires, dans lequel les échantillons intermédiaires sont des échantillons qui ont été traités par l'étape de limitation précédente,

dans lequel chaque étape de limitation supplémentaire (850-3, 850-7) comprend, pour chacun d'au moins un échantillon intermédiaire, le remplacement de l'échantillon intermédiaire concerné par un échantillon réduit en appliquant un offset courant à l'échantillon intermédiaire concerné,

dans lequel l'échantillon réduit a le même signe, mais une magnitude inférieure à celle de l'échantillon intermédiaire concerné,

dans lequel l'offset courant est calculé sur la base des paramètres des sous-filtres et d'une différence de dépassement courante entre le seuil d'écrêtage et une valeur inter-échantillons prédite actuelle générée en appliquant l'un des sous-filtres à une pluralité d'échantillons intermédiaires qui ont été traités par l'étape de limitation précédente.

9.  Dispositif (800, 920) selon la revendication 8, dans lequel la pluralité d'étapes de limitation comporte une dernière étape de limitation (850-7), dans lequel le procédé comporte l'application d'au moins une étape de lissage, chacune de l'au moins une étape de lissage (850-6) étant appliquée après l'une des étapes de limitation mais avant la dernière étape de limitation (850-7).

10. Dispositif (800, 920) selon l'une quelconque des revendications précédentes, dans lequel le dispositif suivant est un dispositif de limitation de bande ou dispositif d'interpolation.

11. Dispositif (800, 920) selon l'une quelconque des revendications précédentes, dans lequel le dispositif suivant est un filtre d'interpolation d'un convertisseur numérique-analogique, DAC.

12. Dispositif (800, 920) selon l'une quelconque des revendications précédentes, dans lequel les moyens de traitement de signal comprennent une circuiterie configurée pour exécuter au moins une étape du procédé.

13. Dispositif (800, 920) selon l'une quelconque des revendications précédentes, dans lequel les moyens de traitement de signal comprennent au moins un processeur et au moins une mémoire comportant des instructions de programme informatique, dans lequel l'au moins une mémoire et les instructions de programme informatique sont configurées pour, avec l'au moins un processeur, amener le dispositif à exécuter au moins une étape du procédé.

14. Procédé comprenant

    - une réception (850-1) d'échantillons d'entrée d'un signal à traiter par un dispositif suivant, dans lequel les valeurs absolues des échantillons d'entrée sont égales ou inférieures à un seuil d'écrêtage ;
    - une exécution d'une étape de limitation (850-2) sur au moins un échantillon d'entrée ;
    dans lequel l'étape de limitation comprend :

        - une génération de valeurs inter-échantillons prédites en appliquant des sous-filtres à des pluralités correspondantes d'échantillons d'entrée incluant l'échantillon d'entrée concerné, dans lequel les sous-filtres modélisent le comportement inter-échantillons du dispositif suivant ; et
        - un remplacement de l'échantillon d'entrée concerné par un échantillon réduit en appliquant un offset à l'échantillon d'entrée concerné,

    dans lequel l'échantillon réduit a le même signe, mais une magnitude inférieure à celle de l'échantillon d'entrée concerné,
    dans lequel l'offset est calculé sur la base de paramètres des sous-filtres et d'une différence de dépassement entre le seuil d'écrêtage et une valeur inter-échantillons prédite.

15. Programme informatique comprenant des instructions qui, lorsqu'elles sont exécutées par au moins un processeur, amènent un dispositif à exécuter un procédé selon la revendication 14.

FIG. 1A

FIG. 1B

FIG. 1C

FIG. 2

EP 4 293 904 B1

FIG. 3A

FIG. 3B

FIG. 3C

FIG. 4A

EP 4 293 904 B1

FIG. 4B

FIG. 4C

EP 4 293 904 B1

FIG. 4D

650

- 650-1 Compute overshoot differences for each interpolated subsample
- 650-2 Scale overshoot differences based on center filter coefficients
- 650-3 Select an offset based on largest scaled overshoot difference
- 650-4 Apply weight w to offset
- 650-5 Subtract sign-corrected offset from time-aligned input sample

FIG. 5

FIG. 6

EP 4 293 904 B1

FIG. 7

EP 4 293 904 B1

900A

910

Audio Device

920

Amplitude Clipping and Limiting

950

DAC

960

Amplifier

FIG. 8A

FIG. 8B

EP 4 293 904 B1

FIG. 8C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018103313 A1
- EP 2369852 A1
- US 2015372650 A1
- US 2015086025 A1
- US 2015207471 A1